Europäisches Patentamt

European Patent Office

Office européen des brevets

(19)

(11) Publication number: **0 375 461**
**A2**

(12) **EUROPEAN PATENT APPLICATION**

(21) Application number: **89313542.6**

(22) Date of filing: **22.12.89**

(51) Int. Cl.5: **H01L 23/498, H01L 23/64**

(30) Priority: **23.12.88 JP 325344/88**
**23.12.88 JP 325346/88**

(43) Date of publication of application:
**27.06.90 Bulletin 90/26**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Nakai, Toshio**
**c/o Patent Division 1-1, Shibaura 1-chome**
**Minato-ku(JP)**

(74) Representative: **Sturt, Clifford Mark et al**
**MARKS & CLERK 57-60 Lincoln's Inn Fields**
**London WC2A 3LS(GB)**

(54) Semiconductor device being packaged.

(57) A semiconductor device having an internal wiring layer which functions as a transmission path in a package, the internal wiring layer comprising a fine wiring portion for allowing a many-pin structure of the semiconductor device and a low electric resistance wiring portion for decreasing the internal wiring resistance. For the fine wiring portion and the low electric resistance wiring portion, two grounding layers for individually forming a micro strip structure are disposed. Alternatively, a grounding layer for forming the fine wiring portion in a micro strip structure and another grounding layer for forming the low electric resistance wiring portion in a coplanar structure are disposed. By considering the distance between these grounding layer and each wiring portion, the characteristic impedance of the entire internal wiring layer is controllably kept constant.

EP 0 375 461 A2

## Semiconductor device being packaged

The present invention relates to a semiconductor device having internal wirings which function as a transmission path.

Generally, a semiconductor element is housed in a package making of ceramics so as to mechanically support itself and to protect itself from ambient air. In addition, in the package, internal wiring layers having desired circuit patterns are formed by co-firing the ceramics. One end portion of each internal wiring layer is electrically connected to electrodes of the semiconductor element. The other end portion is electrically connected to I/O pins. The electrical connections between the semiconductor element and external devices are made by such internal wiring layers, I/O pins, and the like.

For packages of high frequency type semiconductor elements, as the circuit operations are conducted at high speed, assuming that the wiring layers in the packages as transmission paths, it is necessary to keep the the characteristic impedance constant.

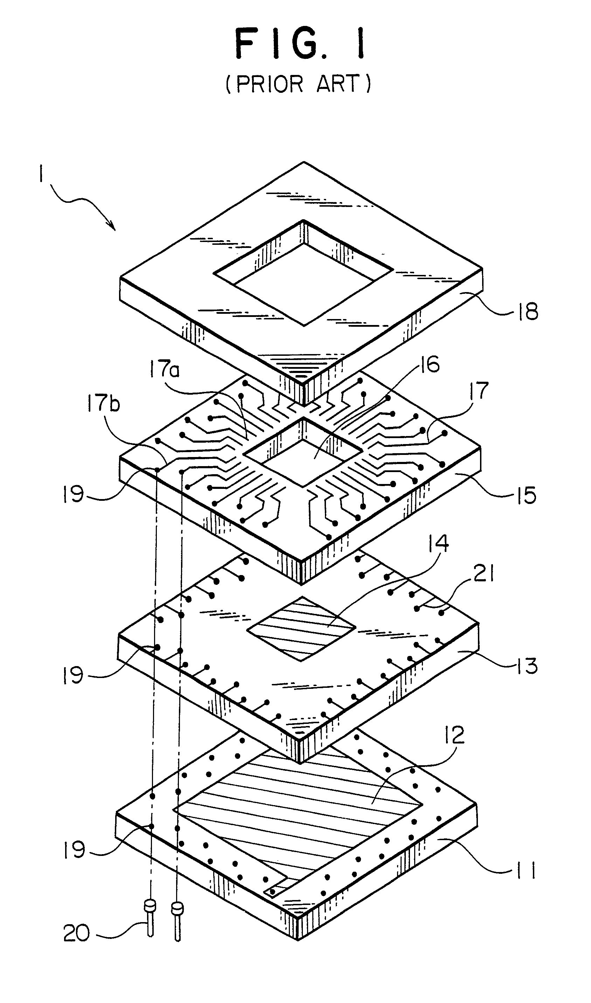

Figure 1 shows an example of a semiconductor element package using a micro strip structure for controlling the characteristic impedance of the wiring layer.

A package 1 shown in the figure is composed of laminated ceramics. On the upper side of a lowest ceramics layer 11, a grounding layer 12 for forming a micro strip structure is disposed. On the upper side of a second ceramics layer 13, a metalize layer 14 for mounting a semiconductor element is formed. On a third ceramics layer 15, a semiconductor element housing portion 16 and an internal wiring layer 17 where signal wires and power supply wires are radially disposed therefrom are formed. The internal wiring layer 17 is protected by a fourth ceramics layer 18. The fourth ceramics layer 18 is provided when required.

One end portion 17a adjacent to the semiconductor element housing portion 16 of the internal wiring layer 17 is electrically connected to the semiconductor element being mounted with bonding wires and the like. An other end portion 17b is electrically connected to I/O pins 20 connected on the lower side of the lowest ceramics layer 1 via a through holes 19 provided on each layer.

The internal wiring layer 17 on the third ceramics layer 15 and the grounding layer 12 on the lowest ceramics layer 11 form the micro strip structure, thereby controlling the characteristic impedance of the internal wiring layer 17.

A wiring pattern 21 provided on the second ceramics layer 13 is a plating wiring for forming bonding pads on the one end portion 17a of the internal wiring layer 17.

On the other hand, as seen in recent VLSI devices, as semiconductor elements are highly integrated, the number of I/O signals per element is increased. For example, in the present logic circuit elements, the number of I/O signals is increased to around 200 to 500.

To satisfy such a requirement for increasing the number of I/O signals, the wire width of the one end portion 7a electrically connected to the semiconductor element on the internal wiring layer 17 in the package should be narrowed. The characteristic impedance of the internal wiring itself in the micro strip structure is determined by the volume of the conductor (by the wire width if the thickness can be ignored). Thus, when the one end portion 7a on the semiconductor element mounting side of the internal wiring layer 17 is narrowed, all the internal wires should have the same wire width. Therefore, besides the connecting portion of the semiconductor element, the wires of the peripheral portion should be also narrowed.

However, when the width of all the wires on the internal wiring layer 17 is narrowed, the conductor resistance is increased and thereby the element is easily affected by an attenuation of the signal voltage of each I/O signal and noise. For example, the occurrence ratio of malfunction of the element will increase.

An object of the present invention is to control the characteristic impedance of the internal wiring for signal wires and power supply wires so as to keep it constant and to provide a semiconductor device where the resistance of the internal wiring is low.

An another object of the present invention is to provide a semiconductor device in a many pin structure while the internal wiring resistance is low.

The semiconductor device of the first invention comprises an insulating substrate in a multiple layer structure where a semiconductor element is mounted, an internal wiring layer formed in the insulating substrate which has both a fine wiring portion disposed at the periphery of the semiconductor element and electrically connected thereto on the one side and a low electric resistance wiring portion electrically connected to the other end of the fine wiring portion, a first grounding layer provided in the insulating substrate for forming the low electric resistance wiring portion in a micro strip structure, and a second grounding layer provided in a plane position which differs from the first grounding layer for forming the fine wiring portion in the micro strip structure.

In the above first invention, the internal wiring layer is composed of a fine wiring portion for providing many pins for the semiconductor device and a low electric resistance wiring portion for decreasing the resistance of the internal wiring itself. In addition, for the fine wiring portion and the low electric resistance portion, two grounding layers forming the micro strip structure are provided. By considering the installation positions of the grounding layers, namely, the distance between the fine wiring portion and the grounding layer and the distance between the low electric resistance wiring portion and the grounding layer, the characteristic impedance of the entire internal wiring layer can be controlled to a constant value.

The semiconductor device of the second invention comprises an insulating substrate in a multiple layer structure where a semiconductor element is mounted, an internal wiring layer formed in the insulating substrate which has both a fine wiring portion disposed at the periphery of the semiconductor element and electrically connected thereto on the one side and a low electric resistance wiring portion electrically connected to the other end of the fine wiring portion, a first grounding layer provided in the insulating substrate for forming the fine wiring portion in a micro strip structure, and a second grounding layer provided in the insulating substrate for forming the low electric resistance wiring portion in a coplanar structure.

In the above second invention, like the first invention, the internal wiring layer is composed of the fine wiring portion and the low electric resistance wiring portion. For the fine wiring portion, a grounding layer for forming the micro strip structure is provided. For the low electric resistance wiring portion, the grounding layer for forming the coplanar structure is provided. By considering the forming position of the grounding layer to the low electric resistance wiring portion, the characteristic impedance of the entire internal wiring layer is controlled to a constant value and the resistance of the internal wiring layer is decreased.

As describe above, according to the present invention, the characteristic impedance of the internal wiring can be kept constant and the resistance can be decreased. In addition, many pins can be easily provided.

Figure 1 is a perspective view showing a package structure of a conventional semiconductor device.

Figure 2 is a perspective view showing a package structure of a semiconductor device of an embodiment of the present invention.

Figure 3 is a sectional view showing a semiconductor device mounting a semiconductor element on the package of Figure 2.

Figure 4 is a perspective view showing a package structure of a semiconductor device of another embodiment of the present invention.

Figure 5 is a sectional view showing a semiconductor device mounting a semiconductor element on the package of Figure 4.

Figure 6 is a schematic describing a characteristic impedance of a coplanar structure.

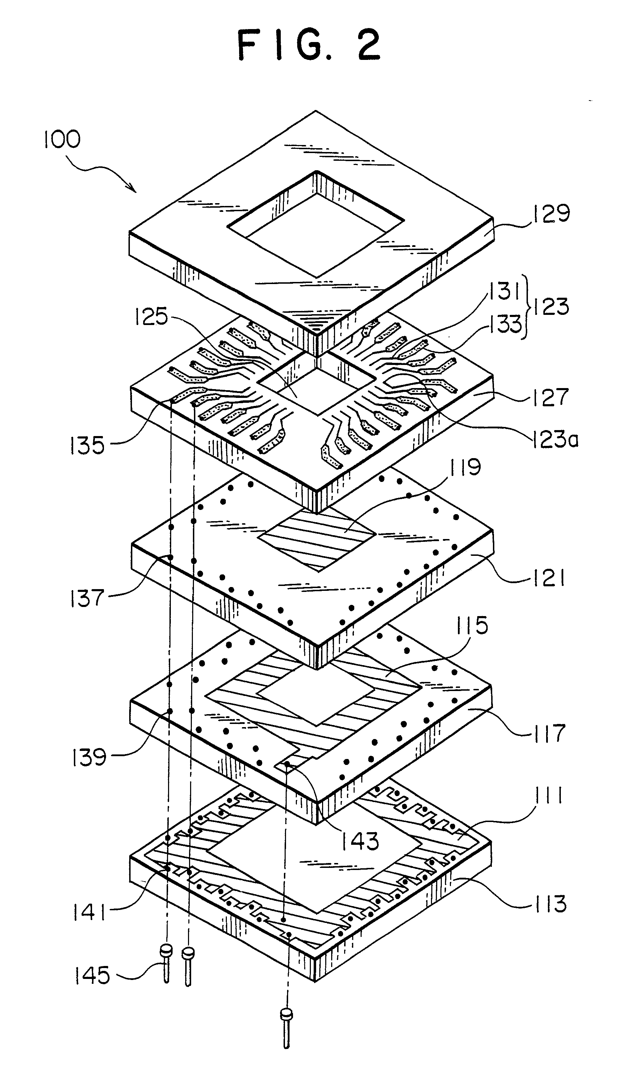

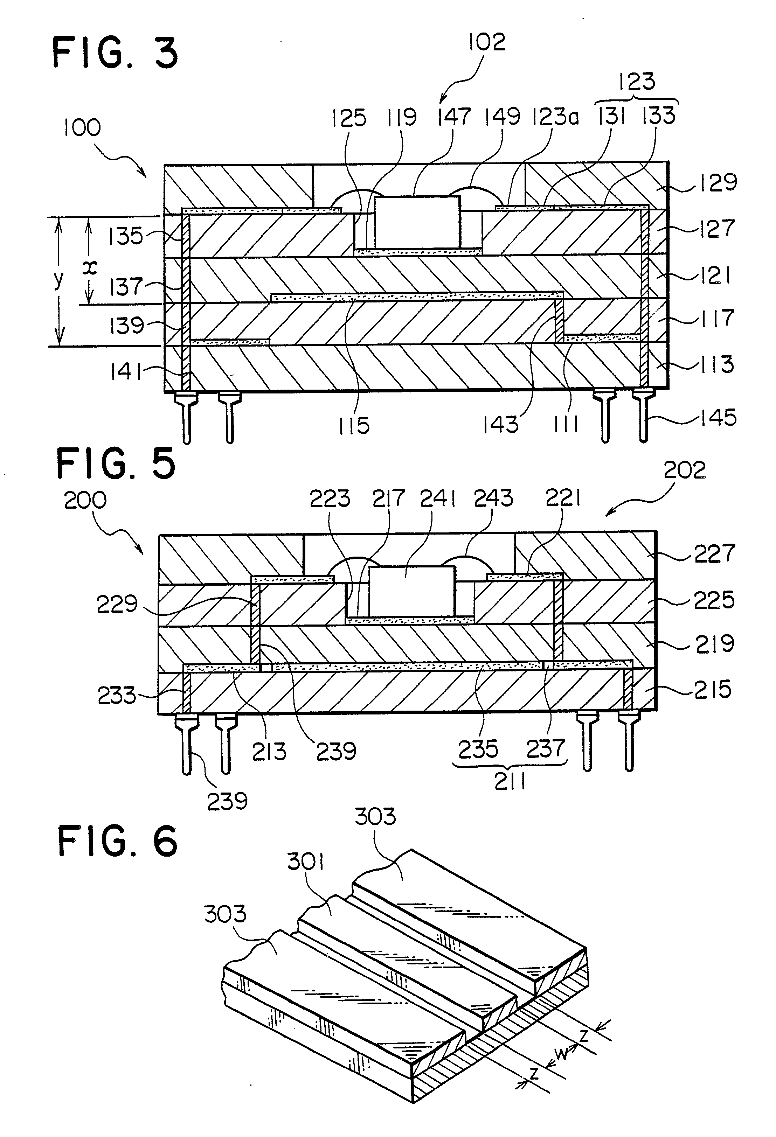

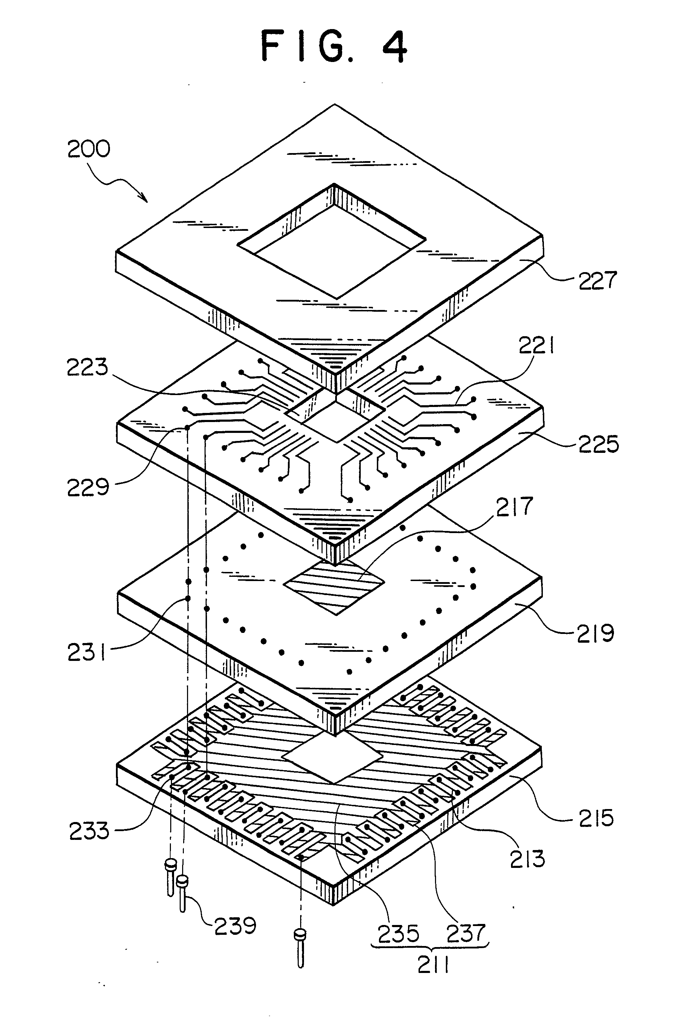

By referring to the attached drawings, an embodiment of a semiconductor device of the present invention is described in the following. Figure 2 is a perspective view showing a package structure of a semiconductor device of an embodiment of the present invention. Figure 3 is a sectional view showing a semiconductor device mounting a semiconductor element on the package of Figure 2.

A semiconductor element package 100 shown in Figure 2 chiefly comprises a first ceramics layer 113 where a first grounding layer 111 is formed on the upper side thereof and which is disposed as the lowest layer, a second ceramics layer 117 where a second grounding layer 115 is formed on the upper side thereof, a third ceramics layer 121 where a metalize layer 119 is formed on the upper side thereof as a semiconductor element mounting layer, a forth ceramics layer 127 where an internal wiring layer 123 where I/O signal wires and power supply wires are formed on the upper side thereof and an opening for a semiconductor element housing portion 125 is made at the middle portion thereof, and a fifth ceramics layer 129 which is a protection layer of the internal wiring layer 123. These ceramics layers 113, 117, 121, 127, and 129 are multiply and co-fired along with the electric conductive layers such as the grounding layers 111 and 115, the metalize layer 119, and the internal wiring layer 123. The fifth ceramics layer 129 is provided when required.

The wiring pattern of the internal wiring layer 123 on the fourth ceramics layer 127 is radially formed from a one end portion 123a which is a bonding portion adjacent to the semiconductor element housing portion 125 to the outer periphery thereof. The internal wiring layer 123 is composed of a fine wiring portion 131 which allows the bonding portion to be wired in a high density and a low electric resistance wiring portion 133 whose wire width is wide for decreasing the conductor resistance and which is continuously disposed from the fine wiring portion 131.

The connection between the fine wiring portion 131 and the low electric resistance wiring portion 133 is made in the manner that an angled end portion of the low electric resistance wiring portion 133 is connected to the fine wiring portion 131 so that the wire width is gradually changed. At the one end portion of the fine wiring portion 131, bonding pads are formed. At the end portion on the outer periphery side of the low electric resistor wiring portion 133, through holes 135 are formed.

On the third ceramics layer 121, the metalize layer which is a semiconductor element mounting plane is formed in accordance with the position of the semiconductor element housing portion 125 opened at the center of the fourth ceramics layer 127. In the positions of the through holes 135 on the fourth ceramics layer 127, through holes 137 are disposed.

On the second ceramics layer 117 and the first ceramics layer 113, through holes 139 and 141 are formed according to the positions of the end portion on the outer periphery side of the low electric resistance wiring portion 133. The second grounding layer 115 on the second ceramics layer 117 is disposed at the center of the areas where the fine wiring portion 131 of the internal wiring layer 123 is formed. In order to increase the joint strength between the ceramics by which the grounding layer is sandwithed, it is desireable to form a blank part in the part of the grounding layer and to increase the joint part between the ceramics. In this example, a blank part 115a is formed in the center so that the blank part does not effect the micre strip structure. The first grounding layer 111 on the first ceramics layer 113 is disposed on the area except for the positions where the through holes 141 area disposed according to the area where the low electric resistance wiring portion 133 is formed and along the outer periphery thereof.

The second grounding layer 115 forms a micro strip structure for the fine wiring portion 131. The first grounding layer 111 forms the micro strip structure for the low electric resistance wiring portion 133. The first grounding layer 111 is electrically connected to the second grounding layer 115 by the conductors in the through holes 143.

On the lower side of the first ceramics layer 113, I/O pins 145 for electrically connecting external devices are connected in the positions according to individual through holes 141.

The semiconductor element package 100 is produced in the following manner, for example.

Through holes and cavities are made on green sheets of the ceramics layers 113, 117, 121, 127, and 129 in accordance with the shape thereof. Conductor paste is applied to the metalize layer 119, the internal wiring layer 123, the grounding layers 111 and 115, and so forth. After conductor paste is filled in the through holes 131, 133, 135, 137, and 139, the individual green sheets are integrally layered as a laminate. After that, the laminate is heated and then the green sheets and the conductor paste are co-fired. After that, the I/O pins 145 are brazed, for example.

As the ceramics materials to be used, various sintered bodies whose major components are alumina and aluminum nitride can be exemplified. However, from a view of heat radiation, it is preferable to use aluminum nitride, because a good thermal conductivity property can be obtained in a high wiring pattern density.

Since the internal wiring layer 123 is formed using conductor paste composed of high melting point metals such as W and Mo so as to it can be co-fired along with other layers, bonding wires composed of Au and the like cannot be directly connected thereto. Instead, bonding pads composed of Ni/Au and the like are electroplated on the end portion (123a) of the fine wiring portion 131 on the internal wiring layer 123. When the bonding pads are electroplated, plating wires (No.21 of Figure 1, for example) which are exposed to the peripheral surface should have been formed in advance. The plating electrode is connected to the exposed portion and then electroplated. However, in this method, the plating wires stay as joints in the internal wires. If the joints stay in the internal wires, as the signal transmission speed increases, signals are reflected from the joints or the transmission waveforms of the signals are remarkably distorted due to signal reflections from termination portions being open, thereby increasing the occurrence ratio of malfunction.

To prevent that, for the semiconductor device package according to the present invention, by connecting the plating electrode to the I/O pins 145 rather than forming the plating wires, they are electroplated. Consequently, the wiring is made without the joints from the I/O pins 145 to the end portion (123a) of the fine wiring portion 131 on the internal wiring layer 123 where the bonding pads are formed as obviously shown in Figure 2.

As shown in Figure 3, a semiconductor element 147 is mounted on the metalize layer 119 on the third ceramics layer 121 and the electrodes of the semiconductor element 147 are connected to bonding pads formed on the one end portion of the fine wiring portion 131 formed on the fourth ceramics layer 127 with boding wires 149, thereby structuring a semiconductor device 102. Although the semiconductor element 147 to be mounted is not limited, the present invention is particularly preferable for high frequency semiconductor elements such as micro wave integrated circuits.

For the individual I/O signal wires (and power supply wires) on the internal wiring layer 123, the second grounding layer 115 forms a micro strip structure for the fine wiring portion 131 and the first grounding layer 111 for the micro strip structure for the low electric resistance wiring portion 133, so that the characteristic impedance of each signal wire is controlled.

The characteristic impedance Zo in the micro strip structure is roughly expressed by the following equation.

$$Zo = \sqrt{L/C}$$

where L is an inductance per unit length of each signal wire; and C is a capacitance per unit length between the signal wire and a grounding layer. Since C is determined by the distance between the signal wire and the grounding layer, the capacitance C1 between the fine wiring portion 131 and the second grounding layer 115 is determined by the distance between the fine wiring portion 131 and the second grounding layer 115, which is represented as x in the figure. The capacitance between the low electric resistance wiring portion 131 and the grounding layer 111 is determined by the distance between the low electric resistance wiring portion 133 and the first grounding layer 111, which is represented as y in the figure. Thus, when the thickness of the fine wiring portion 131 is the same as that of the low electric resistance wiring portion 133, by determining the values of the distance x and the distance y depending on the wire width of the fine wiring portion 131 and the low electric resistance wiring portion 133, the characteristic impedance of the fine wiring portion 131 of each signal wire becomes the same as that of the low electric resistance wiring portion 133.

Since the portion adjacent to the bonding pads of the internal wiring layer of the semiconductor device according to the present embodiment is finely structured, the semiconductor device can be wired in a high density structure and can be used for a many-pin package. In addition, since the wire width of each wire is widened midway, the resistance of each signal wire is decreased, thereby preventing an attenuation of the signal voltage and a malfunction due to noise and the like. Even if the wire width of each wire is changed midway, the positions where the grounding layers are formed according to the fine wiring portion and the low electric resistance wiring portion, that is, the distance between the grounding layer and the internal wiring layer can be adjusted. Therefore, the value of the characteristic impedance can be kept constant. In addition, since the wire width from the fine wiring portion to the low electric resistance wiring portion is gradually widened, a local change of the characteristic impedance can be further decreased.

Therefore, in the semiconductor device of the present embodiment, both a many-pin structure and a low resistance of the wiring can be accomplished at the same time. In addition, by keeping the value of the characteristic impedance of the internal wiring constant, the semiconductor device of the present embodiment can suitably operate as a transmission path of high frequencies.

The internal wiring from the I/O pins to the bonding pads is made without joints. Thereby, when a high frequency semiconductor element is used, even if the transmission speed of signals is increased, it is possible to expect accurate operations without disturbing the transmission waveforms due to reflections.

In the above embodiment, to allow the resistance of the internal wiring layer to be low, the low electric resistance wiring portion whose wire width is wide is provided. However, it is also possible to obtain the same results by thickening the layer of the low electric resistance wiring portion.

The second embodiment of the present invention is described in the following.

Figure 4 is a perspective view showing a package structure of the semiconductor device of another embodiment of the present invention.

A semiconductor element package 200 chiefly comprises a first ceramics layer 215 where a grounding layer 211 and a low electric resistance wiring portion 213 consisting of I/O signal wires and power supply wires of an internal wiring layer are formed, this layer being disposed as the lowest layer, a second ceramics layer 219 where a metalize layer 217 which is a semiconductor element mounting plane is formed, a third ceramics layer 225 where a fine wiring portion 221 of the internal wiring layer are formed on the upper side thereof and an opening of a semiconductor element housing portion 223 is made, and a fourth ceramics layer 227 which is a protection layer of the fine wiring portion 221. These ceramics layers 215, 219, 225, and 227 are integrally sintered and laminated like the first embodiment. The fourth ceramics layer 227 is provided when required.

On the internal wiring layer formed on the third ceramics layer 225, the fine wiring portion 221 is formed for allowing the bonding portion to be wired in a high density structure. The fine wiring portion 221 is radially formed from a portion adjacent to the semiconductor element housing portion 223 to the outer periphery thereof. One end portion of the fine wiring portion 223 is a bonding portion. At the other end portion thereof, through holes 229 are formed.

On the second ceramics layer 219, the metalize layer 217 which is the semiconductor element mounting plane is disposed in accordance with the semiconductor element housing portion 223 which is opened at the center of the third ceramics layer 225. In addition, through holes 231 are formed in positions according to the through holes 229 on the third ceramics layer 225.

On the first ceramics layer 215, the low electric resistance wiring portion 213 is formed from the outer periphery end position of the fine wiring portion 221 on the third ceramics layer 225 to the outer periphery direction thereof. At the other end portion of the low electric resistance wiring portion 213, through holes 233 which are connected to the lower side are formed.

The grounding layer 211 disposed on the first ceramics layer 215 structures a first grounding layer 235 according to the area where the fine wiring portion 221 on the the third ceramics layer 225 is formed, the center portion of the grounding layer 211 being formed on the third ceramics layer 225. The first grounding layer 235 forms a micro strip structure for the fine wiring portion 221. At the outer periphery of the grounding layer 211, a second grounding layer 237 in a comb teeth shape is formed so that the grounding layer can be disposed along both the sides of the low electric resistance wiring portion 213. The second grounding layer 237 forms a coplanar structure for the low electric resistance wiring portion 213.

On the lower side of the first ceramics layer 215, I/O pins 239 are connected to the positions according to the through holes 233 formed on the other end sides of the low electric resistance wiring portion 213.

Like the first embodiment, the semiconductor element package according to the second embodiment is produced by forming through holes on green sheets according to the ceramics layers 215, 219, 225, and 227, printing conductor paste thereon, laminating the individual layers, and co-firing them.

In addition, the bonding pads of the end portion on the inner periphery side of the fine wiring portion 221 are formed by electroplating the I/O pins 239 by connecting a plating electrode like the first embodiment. Consequently, the I/O pins 239 are wired to the bonding pads without joints.

As shown in Figure 5, an semiconductor element 241 which is the same as that of the first embodiment is mounted on the metalize layer 217 of the second ceramics layer 219 and the electrodes of the semiconductor element 241 are connected to the bonding pads formed on the end portion of the fine wiring portion 221 with bonding wires 243, thereby structuring a semiconductor device 202.

The characteristic impedance Zo of the low electric resistance wiring portion 221 is roughly expressed by the following equation like the micro strip structure described above.

$$Zo = \sqrt{L/C}$$

Since the capacitance in the coplanar structure is determined by the ratio of the wire width w of each signal wire 301 and the distance z between a grounding layer 303 and the signal wire, while the characteristic impedance is kept constant, the wire width w of the signal wire 301 can be widened.

Thereby, by adjusting the distance z between the internal wiring and the grounding layer according to the character impedance of the fine wiring portion 221, while the wire width of the low electric resistance wiring portion 213 is widened, the characteristic impedance can be kept to the same value as that of the fine wiring portion 221.

In the semiconductor device according to this embodiment, a high density wiring and many-pin structured package are available. In addition, by changing the wiring structure midway from the micro strip structure to the coplanar structure, the wire width of the internal wiring can be changed, thereby decreasing the resistance of the internal wiring and preventing an attenuation of the signal voltage and a malfunction by noise. By forming the fine wiring portion in the micro strip structure and the low electric resistance wiring portion in the coplanar structure, the characteristic impedance value can be kept constant.

Since the semiconductor element package according to this embodiment forms the micro strip structured grounding layer and the coplanar structured grounding layer with a grounding layer on the same plane, the package can be produced at the nearly same cost as the conventional micro strip structured packages without increasing the number of the ceramics layers.

In the above embodiment, to allow the resistance of the wiring layer to be decreased, the low electric resistance wiring portion whose wire width is wide is provided. However, it is also possible to obtain the same results by thickening the layer of the low electric resistance wiring portion.

**Claims**

1. A semiconductor device comprising:
a insulating substrate multiply layered for housing a semiconductor element;
an internal wiring layer disposed in said insulating substrate, said internal wiring layer having a fine wiring portion disposed at a periphery of said semiconductor element and electrically connected to said semiconductor element on one end thereof and a low electric resistance wiring portion electrically connected to the other end of said fine wiring portion;
a first grounding layer disposed in said insulating substrate for forming said low electric resistance wiring portion in a micro strip structure; and
a second grounding layer disposed in a plane position in said insulating substrate differing from said first grounding layer for forming said fine wiring portion in said micro strip structure.

2. The semiconductor device of claim 1 wherein:
said fine wiring portion and said low electric resistance wiring portion are continuously formed on a same plane, the distance between the plane where said fine wiring portion and said low electric resistance wiring portion are formed and said first grounding layer and that between the plane and said second grounding layer being predetermined so that a characteristic impedance of said fine wiring portion nearly becomes the same as that of said low electric resistance wiring portion.

3. The semiconductor device of claim 1 wherein:
the wire width of said low electric resistance wiring portion is wider than that of said fine wiring portion for decreasing the conductor resistance, said fine wiring portion being connected to said low electric resistance wiring portion, thereby gradually changing the wire width.

4. The semiconductor device of claim 1 wherein:
the layer of said low electric resistance wiring portion is thicker than that of said fine wiring portions for decreasing the conductor resistance.

5. The semiconductor device of claim 1 wherein:
said insulating substrate has I/O pins electrically connected to said internal wiring layer, said I/O pins being wired to a connection portion of said semiconductor element of said fine wiring portion without joints.

6. The semiconductor device of claim 1 wherein:
said insulating substrate is composed of aluminum nitride.

7. A semiconductor device comprising:
an insulating substrate multiply layered for housing a semiconductor element;
an internal wiring layer disposed in said insulating substrate, said internal wiring layer having a fine wiring portion disposed at a periphery of said semiconductor element and electrically connected to said semiconductor element at one end portion thereof and a low electric resistance wiring portion electrically connected to the other end portion of said fine wiring portion;
a first grounding layer disposed in said insulating substrate for forming said fine wiring portion in a micro strip structure; and
a second grounding layer disposed in said insulating substrate for forming said low electric resistance wiring portion in a coplanar structure.

8. The semiconductor device of claim 7 wherein:
said first grounding layer and said second grounding layer are formed on a same plane, said second grounding layer being extruded from said first grounding layer in a comb teeth shape.

9. The semiconductor device of claim 7 wherein:
said fine wiring portion and said low electric resistance wiring portion are formed on different planes, said fine wiring portion and said electric resistance wiring portion being electrically connected via through holes.

10. The semiconductor device of claim 7 wherein:
the wire width of said low electric resistance wiring portion is wider than that of said fine wiring portion for decreasing the conductor resistance.

11. The semiconductor device of claim 7 wherein:
the thickness of said low electric resistance wiring portion is larger than that of said fine wiring portion for decreasing the conductor resistance.

12. The semiconductor device of claim 7 wherein:
The distance between said fine wiring portion and said first ground layer and that between said low electric resistance wiring portion and said second grounding layer are predetermined so that the characteristic impedance of said fine wiring portion nearly becomes the same as that of said low electric resistance portion.

13. The semiconductor device of claim 7 wherein:
said insulating substrate has I/O pins electrically connected to said internal wiring layer, said I/O pins being wired to a connection portion of said semiconductor element of said fine wiring portion without joints.

14. The semiconductor device of claim 7 wherein:
said insulating substrate is composed of aluminum nitride.

# F I G. 1
( PRIOR ART )

# F I G. 2

# FIG. 3

# FIG. 5

# FIG. 6

# FIG. 4